# EUROPEAN PATENT APPLICATION

(11) **EP 4 443 502 A1**
(43) Date of publication of application: **09.10.2024**
(21) Application number: 24165985.3
(22) Date of filing: 25.03.2024
(51) Int. Cl.: H01L 25/065, H01L 23/31

(54) **MULTIDEVICE PACKAGE WITH RECESSED MOUNTING SURFACE**

(30) Priority: 03.04.2023 US 202318295230
(71) Applicant: NXP USA, Inc., Austin TX 78735 (US)
(72) Inventor: KANTH, Namrata, 5656AG Eindhoven (NL); HAYES, Scott M, 5656AG Eindhoven (NL); HOOPER, Stephen Ryan, 5656AG Eindhoven (NL); SAKLANG, Chayathorn, 5656AG Eindhoven (NL); CARPENTER, Burton Jesse, 5656AG Eindhoven (NL)
(74) Representative: Krott, Michel

(57) **Abstract**

A multidevice package includes upper and lower surfaces with the lower surface disposed beneath a first die forming part of the package. The lower surface includes a first a set of electrical contacts and a recessed region with a second set of electrical contacts configured to allow a second die to be coupled to the lower surface and electrically coupled to the first die via the second set of contacts. The recessed region is sufficiently recessed to allow the package to be coupled to a mounting surface such as a printed circuit board via the first set of contacts while the second die remains suspended above the mounting surface.

## Description

### Field of the Invention

Embodiments of the subject matter described herein relate to packages for semiconductor and other electronic devices.

### BACKGROUND OF THE INVENTION

Multiple devices such as semiconductor chips may be packaged together in a single device package to achieve higher density and/or improved integration of interconnected components. Some multiple device packages include packages having one or more exterior surfaces on which additional devices are mounted to expose sensing elements such as optical sensors, chemical, sensors, gas sensors, and the like.

### SUMMARY OF THE INVENTION

In an example embodiment, a device package includes a lower package surface disposed opposite an upper package surface. The lower package surface includes a first region provided with a first set of electrical contacts and a second region that is recessed with respect to the upper package surface and provided with a second set of electrical contacts. The device package further includes a first die that is disposed above the lower package surface and coupled to the first and second sets of electrical contacts. The second region of the lower package surface is configured to allow another die to be coupled to the second set of electrical contacts disposed on the lower package surface in the second region. The second region of the lower package surface is further configured to allow the device package to be bonded to a substrate via the first set of electrical contacts.

In another example embodiment, a device package includes a lower package surface disposed opposite an upper package surface. The lower package surface includes a first region provided with a first set of electrical contacts and a second region that is recessed with respect to the upper package surface and provided with a second set of electrical contacts. The device package further includes a first die that is disposed above the lower package surface and coupled to the first and second sets of electrical contacts. The second die is coupled to the second set of electrical contacts disposed on the lower package surface in the second region. The second region of the lower package surface and the second die are configured and arranged to allow the device package to be bonded to a bonding surface via the first set of electrical contacts such that the second die is suspended above the bonding surface.

In another example embodiment, a method of forming a device package includes forming a lower package surface beneath a first die from encapsulant material; forming a first region of the lower package surface provided with a first set of electronic contacts that are electrically coupled to the first die; and forming a second region of the lower package surface that is recessed with respect to the first region and provided with a second set of electrical contacts that are electrically coupled to the first die. The second region is configured to receive an additional die and the device package is configured and arranged to allow the device package to be bonded to another surface via the first set of electrical contacts such that the additional die is suspended above the other surface.

In one or more embodiments, the method further includes disposing, as the additional die on the lower package surface, a second die within the second region and electrically coupling the second die to the second set of electrical contacts.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1A is cross-sectional schematic view of a multi-device package according to one or more embodiments.
FIG. 1B is schematic plan view of the package of FIG. 1A.
FIG. 2 is a schematic process flow diagram showing the package of FIG. 1A and 1B during steps of an example fabrication process according to one or more embodiments.
FIG. 3 is a schematic process flow diagram showing the package of FIG. 1A and 1B during steps of an alternative fabrication process according to one or more embodiments.
FIG. 4 depicts plan views of device packages according to various embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration or with reference to any other suitable orientations or axes.

It will be appreciated that the steps of various processes described herein are non-limiting examples of suitable processes according to embodiments and are for the purposes of illustration. Systems and devices according to embodiments herein may be use any suitable processes including those that omit steps described above, perform those steps and similar steps in different orders, and the like. It will also be appreciated that well-known features may be omitted for clarity.

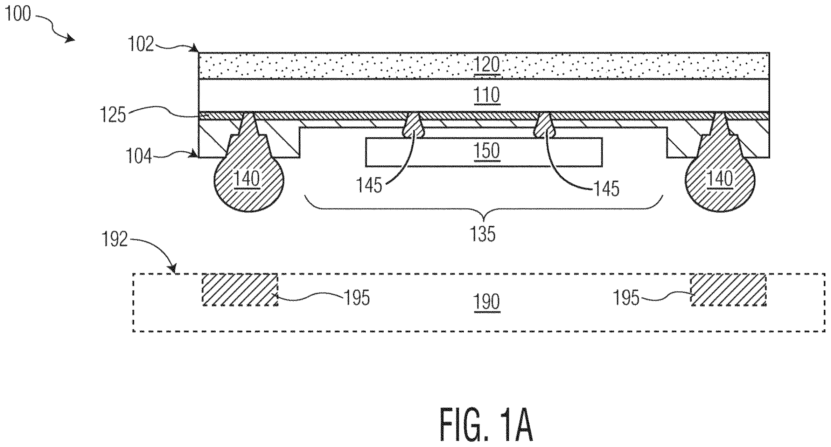

FIG. 1A is a cross-sectional view of an example device package according to one or more embodiments. The package 100 includes a first device (a die 110) that is encapsulated by one or more encapsulant materials (i.e., the encapsulant material 120, the encapsulant material 125, and the encapsulant material 130), forming an upper package surface 102 "above" the die 110 and a lower package surface 104 "below" the die 110. The lower package surface 104 includes a recessed region 135 that is recessed with respect to portions of the encapusulant material 130 forming one or more other regions of the lower package surface 104. A first set of electrical contacts 140 are electrically coupled to the first die 110 and extend beyond the lower package surface 104. As shown, in one or more embodiments, a first set of electrical contacts such as the electrical contacts 140 are configured and arranged such that the package 100 can be electrically and mechanically coupled to the surface of a substrate or other device (e.g., the substrate 190 depicted with bond pads 195).

The package 100 is provided with a second set of electrical contacts (the electrical contacts 145) disposed within the recessed region 135. As shown, in one or more embodiments, a second device (a die 150) is coupled to the first die 110 via this second set of electrical contacts. Each of the electrical contacts 145 pass through the encapsulant materials 125, 130. In one or more embodiments, as shown in FIG. 1A, a second device such as the die 150 extends beyond the lower package surface 104 by a first distance and a first set of electrical contacts such as the electrical contacts 140 extend beyond the lower package surface 104 by a second distance that is greater than the first distance. As a result, in such embodiments, when a package such as the package 100 is coupled to another surface such as the surface 192 of the substrate 190 via the electrical contacts 140, the a die such as the die 150 can remain suspended above that surface.

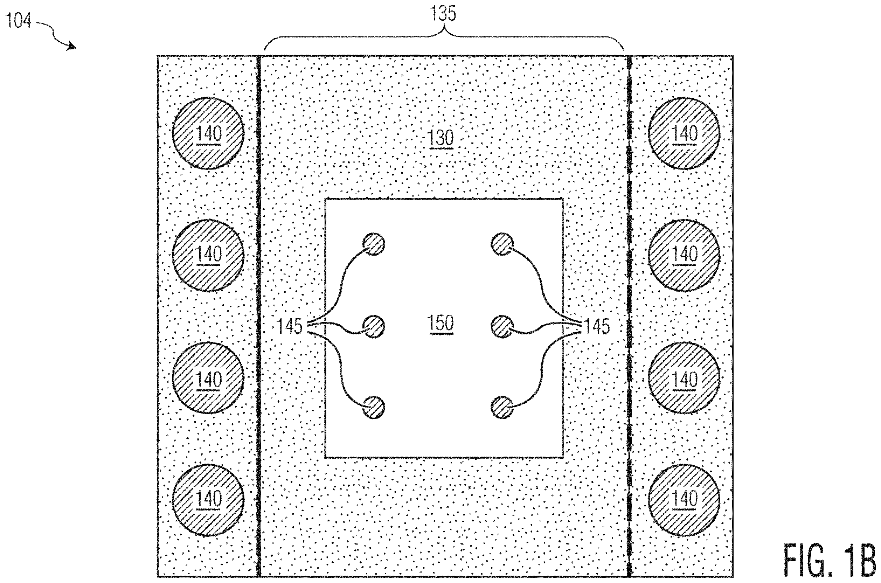

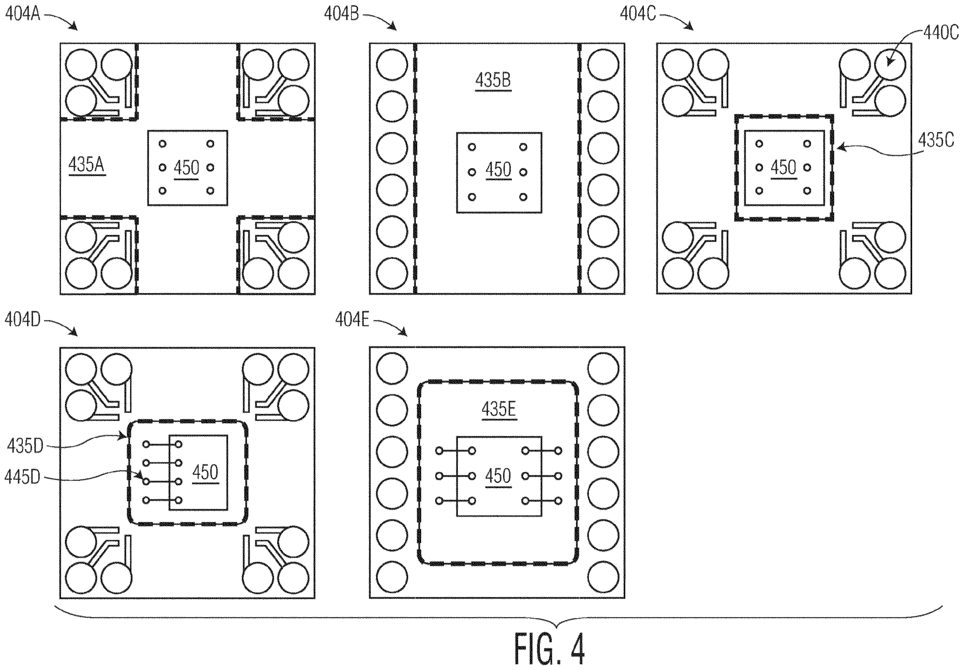

FIG. 1B depicts a plan view of the lower package surface 104 of the package 100. The die 150 is shown with the electrical contacts 145 beneath it, disposed on the lower package surface 104 within the recessed region 135. Electrical contacts 140 are shown to either side of the recessed region 135. It will be understood that the number and arrangement of electrical contacts 140 and electrical contacts 145 in FIGs. 1A-1B are for purposes of illustration and that any suitable number and arrangement of contacts may be used in one or more embodiments. Further nonlimiting examples of arrangements of contacts according to various embodiments are described below in connection with FIG. 4.

It will be appreciated that packages according to embodiments herein such as the package 100 can have various desirable characteristics. For example, placement of a second electronic device such as the die 150 in a recessed region such as the recessed region 135, allows the second device to be physically separated the bulk of the package and physically separated from the first set of electrical contacts used to bond the device package to a substrate. As a result, the second device may be protected from exposure to undesired stresses in the device package. Additionally, the second device may include a pressure sensing element or the like. Such devices often require a protective cover to protect them against debris or other damage. However, when a pressure sensor is bonded to a package such as the package 100 and that package is bonded to a substrate as pictured in FIG. 1A, the package itself can be used to protect the device bonded to the lower package surface in the recessed region (e.g., the recessed region 135 of the lower package surface 104).

It will be appreciated that nothing herein requires a particular orientation of the package 100, including the upper package surface 102 and the lower package surface 104 and that, for purposes of illustration, the package 100 may be depicted in an inverted orientation relative to such descriptions in order to illustrate particular features in subsequent descriptions. Any suitable materials may be used as the encapsulant materials 120, 125, and 130. Non-limiting examples of suitable materials include: epoxy-based molding compounds, polyamide, Ajinomoto build-up film (ABF) and the like.

Furthermore, it will be appreciated that the arrangement of encapsulant 120, 125, and 130 of FIG. 1A and FIG. 1B is a nonlimiting example and that any suitable arrangement of such materials may be used in one or more embodiments. As one example, in one or more embodiments, a single encapsulant material is used throughout. As another example, in one or more embodiments, an encapsulant such as the encapsulant 120 is omitted and an exposed surface of a device such as the die 110 forms an upper package surface such as the upper package surface 102.

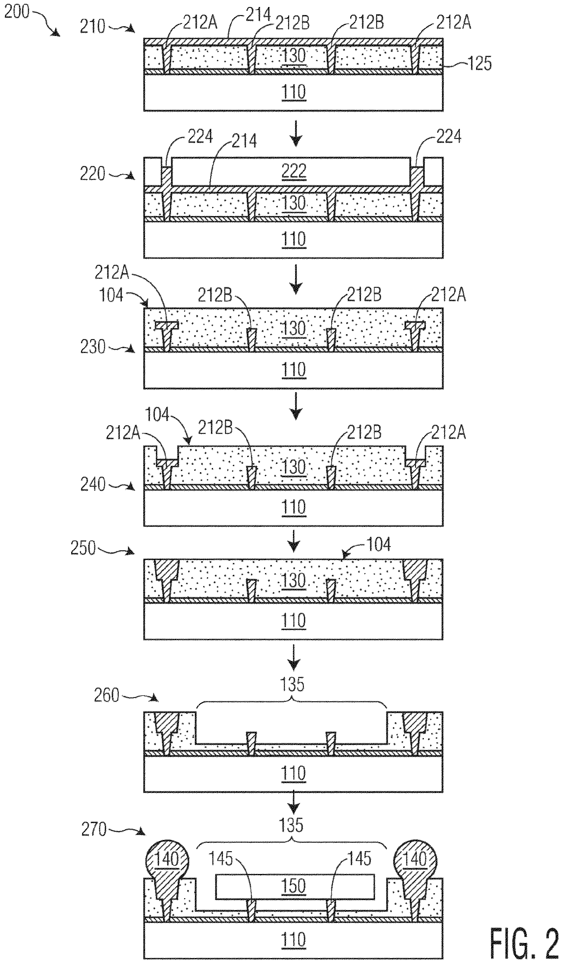

FIG. 2 is process-flow diagram illustrating the package 100 in cross-section during steps of an example process suitable for forming packages according to one or more embodiments. It will be appreciated that in one or more embodiments, steps of the process 200 or similar steps may be omitted, added, or performed in a different order than shown in FIG. 2 and that intermediate steps may not be shown. The process 200 is described below in connection with steps 210, 220, 230, 240, 250, 260, and 270. The encapsulant material 120 is not shown and can be formed at any suitable step. For instance, in one or more embodiments, an encapsulant material such as the encapsulant material 120 is formed around the die 110 prior to step 210, as one nonlimiting example. Meanwhile, in one or more embodiments, an encapsulant material such as the encapsulant material 120 is formed at a later step.

At step 210, the encapsulant material 125 and the encapsulant material 130 have been formed on the surface shown of the die 110 and subsequently patterned with apertures through which an electrically conductive material (the conductive material 212) is deposited. The conductive material 212 may be any suitable material including, as non-limiting examples, gold, copper, aluminum, nickel, titanium alloys thereof, and the like. The conductive material 212 is patterned using any suitable process(es) into pillars 212A and 212B that contact the die 110 as shown. In one example, the conductive material 212 may be formed by deposition through a lithographically patterned mask (e.g., photoresist) in a lift-off process leaving the conductive material 212 only in the desired areas, followed by blanket deposition (e.g., by sputtering or thermal evaporation) of a thin conductive layer 214 that overlies the pillars 212A and 212B and the encapsulant material 130. It will be understood that the thickness of the conductive layer 214 is not shown to scale and that the thickness of the conductive layer 214 may be chosen to allow it to be removed in a later step (e.g., at step 220). As illustrated in subsequent steps, outer pillars 212A will form part of each of the first set of electrical contacts (the electrical contacts 140) and inner pillars 212B will form all or part of each of the second set of electrical contacts (the electrical contacts 145).

At step 220, a mask material 222 (e.g., photoresist) is patterned over the conductive material 212 to expose the conductive material 212 in the areas where the contacts 140 will be formed. Additional conductive material 224 is then deposited through the mask material 222 using any suitable process (e.g., by electroplating). The mask material 222 can then be removed and the residual portions of conductive layer 214 that are not protected by the additional conductive material 224 can be removed by any suitable process such (e.g., using a wet chemical etch, or using a dry plasma etch).

At step 230, the conductive layer 214 is removed, leaving behind the pillars 212A, 212B formed from the material 212 and a portion of additional conductive material 224 above the pillars 212A. In this example, the outer pillars corresponding to the electrical contacts 140 are enlarged and extend further than the inner pillars 212B corresponding to the electrical contacts 145. Additional encapsulating material 130 is formed over the conductive pillars.

At step 240, the encapsulating material 130 is patterned (e.g., via photolithography, laser etching, or any other suitable process) to expose the tops of the outer pillars corresponding to the electrical contacts 140. The encapsulating material 130 may be patterned using a photoresist as a mask material or, in one or more embodiments, the encapsulating material 130 is a photosensitive material that can be photolithographically patterned directly.

At step 250, additional conductive material is deposited (e.g., by plating or any other suitable method) such that the conductive material of the outer pillars corresponding to the electrical contacts 140 extend through the entire thickness of the encapsulating material 130 to the die 110. The surface of the encapsulating material 130 may be planarized (e.g., using a mechanical or chemical-mechanical polishing process).

At step 260, the encapsulating material 130 is patterned (e.g., using a photolithographic process, laser/plasma etching, precision milling, or any other suitable process) to form the recessed region 135 and to expose the conductive material of the inner pillars 212B corresponding to the electrical contacts 145 within the recessed region 135.

At step 270, additional conductive material (e.g., solder bumps) is bonded to the outer pillars 212A and the inner pillars 212B to complete the electrical contacts 140 and the electrical contacts 145, respectively. The die 150 is then bonded to the electrical contacts 145, bonding the die 150 to the lower package surface 104 and coupling the die 150 to the die 110, as shown.

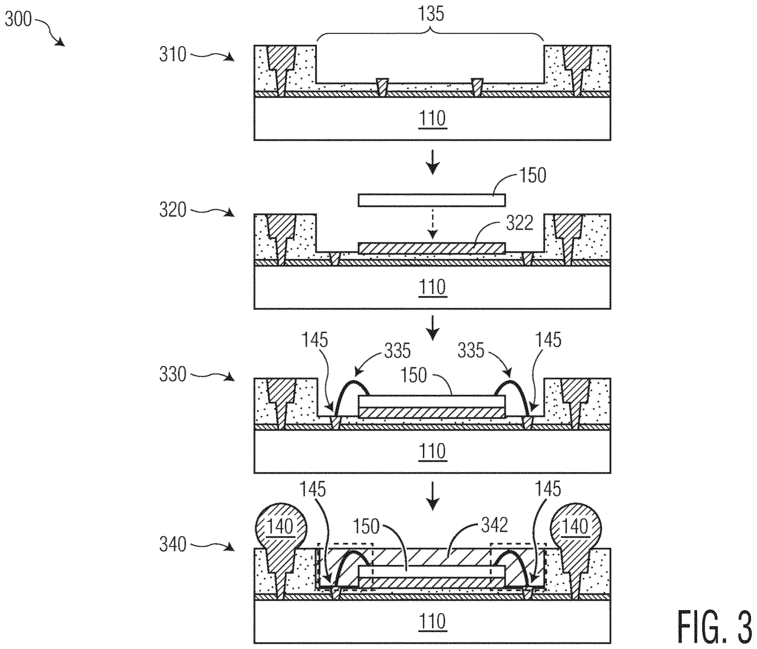

FIG. 3 is process-flow diagram illustrating the package 100 in cross-section during steps of an alternate process suitable for forming packages according to one or more embodiments. It will be appreciated that in one or more embodiments, steps of the process 300 or similar steps may be omitted, added, or performed in a different order than shown in FIG. 3 and that intermediate steps may not be shown. The process 300 is described below in connection with steps 310, 320, 330, and 340. In one or more embodiments, the steps 310-340 or similar steps are performed in place of the steps 260-270 of the process 200.

At step 310 (e.g., step 260 of the process 200), the encapsulating material 130 is patterned (e.g., using a photolithographic process or any other suitable process) to form the recessed region 135 and to expose the conductive material of the inner pillars corresponding to the electrical contacts 145 within the recessed region 135.

At step 320, a bonding material 322 is dispensed or otherwise formed above the encapsulating material 130 within the recessed region 135 and the die 150 is bonded to the surface of the encapsulating material 130 via the bonding material 322 as shown.

At step 330, the die 150 is coupled the electrical contacts 145 via wire bonds 335.

At step 340, additional conductive material (e.g., solder bumps) is bonded to the outer pillars to complete the electrical contacts 140. In one or more embodiments, a die such as the die 150 is encapsulated using additional encapsulating material 342 in order to protect the wire bonds 335. In one or more embodiments, encapsulating material such as the, the encapsulating material 342 is patterned to expose part of a die such as the die 150 to the surrounding environment.

FIG. 4 shows plan views of four non-limiting example arrangements of packages according to embodiments herein having a device 450 disposed within recessed regions 435 (the recessed regions 435A, 435B, 435C, 435D, and 435E of respective lower package surfaces 404A, 404B, 404C, 404D, and 404E e.g., the recessed region 135 of the lower package surface 104). As shown, the lower package surface 404D includes the device 450 bonded to contacts such as the electrical contacts 145 of FIG. 1.

The recessed region 435A of the lower package surface 404A extends to the edges of the lower package surface 404A and is surrounded by remaining (raised) portions of the lower package surface 404A at the corners of the lower package surface 404A. The lower package surface 404B is similar to the lower package surface 104 of FIG. 1, with the recessed region 435B extending to two edges of the lower package surface 404. The lower package surface 404C includes a recessed region 435C in its center which is surrounded by the remained (raised) portion of the lower package surface 404C provided with radially arranged contacts 440C. The lower package surface 404D includes a recessed region 435D in which the die 150 is bonded to electrical contacts 445D via wire bonds (e.g., as shown in FIG. 3). The lower package surface 404D includes a central recessed region 435D in which the device 450 is bonded to electrical contacts 445D via wire bonds (e.g., as shown in FIG. 3). Finally, the lower package surface 404E includes a larger recessed region 435E in which the device 450 is bonded to electrical contacts 445D via wire bonds on two edges of the device 450.

It will be understood that the examples of FIG. 4 are intended for purposes of illustration only and that various embodiments may employ any suitable arrangement with one or more recessed regions (e.g., any of the recessed regions 135, 435) disposed on a lower package surface and contacts to a device such as the die 150, 450. It will be further understood that nothing herein is intended to limit embodiments to any particular number or arrangement of devices encapsulated within a device package or any particular number or arrangement of devices disposed on a lower package surface of such a package.

### EXAMPLE EMBODIMENTS

Features of embodiments may be understood by way of one or more of the following examples:
Example 1: A device package or method of forming a device package that includes a lower package surface formed opposite an upper package surface. The lower package surface includes a first region provided with a first set of electrical contacts and a second region that is recessed with respect to the upper package surface and provided with a second set of electrical contacts. A first die is disposed above the lower package surface and coupled to the first and second sets of electrical contacts. The second region is configured to receive a second die coupled to the second set of electrical contacts disposed on the lower package surface in the second region. The second region of the lower package surface and the second die are configured and arranged to allow the device package to be bonded to a bonding surface via the first set of electrical contacts such that the second die is suspended above the bonding surface.
Example 2: the device package or method of Example 1 in which the first die device is encapsulated by an encapsulant material. The first and second set of electronic contacts pass through the encapsulant material to electrically contact the first die.
Example 3: the device package or method of Example 1 or Example 2 in which a second die is coupled to the second set of electrical contacts via one or more wire bonds.
Example 4: the device package or method of any of Examples 1-3 in which a second die is coupled to the second set of electrical contacts via one or more solder bumps.
Example 5: the device package or method of any of Examples 1-4 in which each electrical contact of the first set of electrical contacts includes a solder bump that extends above the lower package surface and forms a distal end of that electrical contact.
Example 6: the device package or method of any of Examples 1-5 in which a second die extends above the lower package surface to a first height that is lower than a height of the distal end of each electrical contact of the first set of electrical contacts.
Example 7: the device package or method of any of Examples 1-6 in which the upper package surface is formed by a surface of the first die.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. A device package comprising:
a lower package surface disposed opposite an upper package surface, the lower package surface comprising a first region provided with a first set of electrical contacts and a second region that is recessed with respect to the first region of the lower package surface and provided with a second set of electrical contacts;
a first die that is disposed within the device package between the upper package surface and the lower package surface and coupled to the first and second sets of electrical contacts; and
a second die that is coupled to the second set of electrical contacts and is disposed on the lower package surface in the second region;
wherein the second region of the lower package surface and the second die are configured and arranged to allow the device package to be bonded to a bonding surface via the first set of electrical contacts such that the second die is suspended above the bonding surface.

2. The device package of claim 1:
wherein the first die is encapsulated by an encapsulant material; and
wherein the first and second set of electronic contacts pass through the encapsulant material to electrically contact the first die.

3. The device package of claim 2:
wherein the second die is coupled to the second set of electrical contacts via one or more wire bonds.

4. The device package of claim 2:
wherein the second die is coupled to the second set of electrical contacts via one or more solder bumps.

5. The device package of any one of claims 2 to 4:
wherein each electrical contact of the first set of electrical contacts includes a solder bump that extends beyond the lower package surface and forms a distal end of that electrical contact.

6. The device package of claim 5:
wherein the second die extends beyond the lower package surface to a first height that is less than a height of the distal end of each electrical contact of the first set of electrical contacts.

7. The device package of any preceding claim:
wherein the upper package surface is a surface of the first die.

8. A method of forming a device package, the method comprising:
forming, from encapsulant material, a lower package surface disposed on a first die;
forming a first region of the lower package surface provided with a first set of electronic contacts that are electrically coupled to the first die; and
forming a second region of the lower package surface that is recessed with respect to the first region of the lower package surface and provided with a second set of electrical contacts that are electrically coupled to the first die;
wherein the second region of the lower package surface is configured to
receive an additional die and the device package is configured and
arranged to allow the device package to be bonded to another surface via the first set of electrical contacts such that the additional die is suspended above the other surface.

9. The method of claim 8, further comprising:
disposing, as the additional die on the lower package surface, a second die within the second region and electrically coupling the second die to the second set of electrical contacts.

10. The method of claim 9, wherein the first and second set of electronic contacts pass through the encapsulant material to electrically contact the first die.

11. The method of claim 9 or 10, further comprising:
coupling the second die to the second set of electrical contacts via one or more wire bonds.

12. The method of claim 9 or 10, further comprising:
coupling the second die to the second set of electrical contacts via one or more solder bumps.

13. The method of any one of claims 9 to 12:
wherein each electrical contact of the first set of electrical contacts includes a solder bump that extends beyond the lower package surface and forms a distal end of that electrical contact.

14. The method of claim 13:
wherein the second die extends beyond the lower package surface to a first height that is less than a height of the distal end of each electrical contact of the first set of electrical contacts.
